Europäisches Patentamt

**European Patent Office**

**Office européen des brevets**

(19)

(11) Publication number: **0 067 738**
**A2**

(12) # EUROPEAN PATENT APPLICATION

(21) Application number: **82400922.9**

(22) Date of filing: **18.05.82**

(51) Int. Cl.³: **H 01 L 21/76**
**H 01 L 21/31**

(30) Priority: **26.05.81 US 266767**

(43) Date of publication of application:
**22.12.82 Bulletin 82/51**

(84) Designated Contracting States:
**DE FR GB IT NL**

(71) Applicant: **FAIRCHILD CAMERA & INSTRUMENT CORPORATION**
**464 Ellis Street**
**Mountain View California 94042(US)**

(72) Inventor: **Padmanabhan, G. R.**
**956 Redwood Avenue**
**Sunnyvale California 94086(US)**

(74) Representative: **Chareyron, Lucien et al,**
**Schlumberger Limited 42, rue Saint-Dominique**
**F-75340 Paris Cedex 07(FR)**

(54) **Method of reducing encroachment in a semiconductor device.**

(57) A nitride layer of a semiconductor device is etched to expose a portion of a layer of silicon dioxide, in turn disposed on a semiconductor substrate, and a thin layer of polysilicon is deposited over the resulting structure prior to growth of an insulating region in the form of a field oxide, with the nitride layer being used as a mask.

FIG.2d

30
24
22a
20

EP 0 067 738 A2

## BACKGROUND OF THE INVENTION

This invention relates to semiconductors, and more particularly, to a method of forming a field oxide in a semiconductor device.

Reference is made to Patent No. 3,913,211 to Seeds et al, dated October 21, 1975 and assigned to the assignee of this invention. That patent discloses a method of manufacturing an MOS transistor. As provided therein, a silicon nitride layer (disposed on a thin oxide layer in turn disposed on a semiconductor substrate) is etched to provide an opening, and an insulating region in the form of a field oxide is grown, the positioning and sizing of such field oxide being determined by the configuration of the nitride layer after etching. As disclosed in detail in that patent, in formation of the field oxide, the oxide tapers gradually from the full thickness of the field oxide to the thickness of the (relatively thin) gate oxide. Such taper provides the advantage that it makes possible the subsequent contacting of source and drain regions by leads crossing the field oxide and then dropping gradually to the elevation of the gate oxide without the high probability of open circuits due to steps in the oxide.

While such a taper is advantageous in accordance with that patent, it will be understood that it is considered highly desirable to provide close packing of semiconductor devices, to increase the packing density of a chip. Such close packing can be achieved with more extreme taper, yet it must be insured that the taper is smooth so as to avoid open circuits as described above.

## SUMMARY OF THE INVENTION

It is accordingly an object of this invention to provide a method of forming a field oxide for a semiconductor device so as to provide more extreme taper between the body of the field oxide and the gate oxide than in the prior art.

Broadly stated, the invention comprises a method of forming an insulating region for a semiconductor device comprising providing a substrate of semiconductor material, providing a layer of oxide over the substrate, forming a nitride mask over the oxide which defines an opening exposing a portion of the oxide, providing a layer of polysilicon over the resulting structure, and oxidizing the resulting structure to grow an insulating region.

## BRIEF DESCRIPTION OF THE DRAWINGS

Other objects of the invention will be apparent from a study of the following specification and drawings, in which:

Figs. 1a through 1d show process steps illustrating a prior art system of forming a semiconductor device; and

Figs. 2a through 2f show process steps illustrating the present invention.

## DESCRIPTION OF THE PREFERRED EMBODIMENT

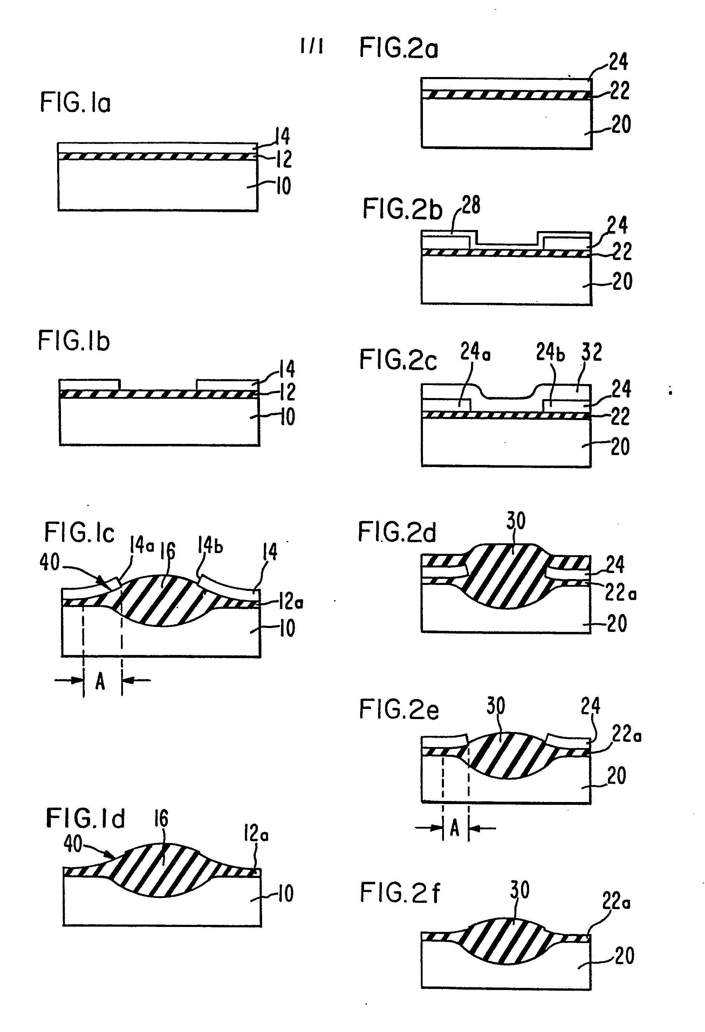

As shown in Fig. 1a, a substrate 10 of semiconductor material, i.e., for example silicon, has formed on it an oxide layer 12. Typically, oxide 12 is formed by thermal oxidation of the substrate 10. A layer of silicon nitride 14 is formed over the oxide 12. Selective nitride etching is then undertaken to expose a portion of the oxide 12 (Fig. 1b), such etching taking place, for example, in accordance with U.S. Patent No. 3,913,211.

The resulting structure is then placed in an oxidizing environment at an elevated temperature. The oxygen in the environment combines with the silicon from silicon substrate 10 to form a thick region of oxidized semiconductor material, i.e., insulation region or field oxide 16 (Fig. 1c). The nitride 14 is then etched, resulting in the structure shown in Fig. 1d. Remaining steps as shown in U.S. Patent No. 3,913,211 can be undertaken to complete the semiconductor device.

Similar to the disclosure in that patent, the thick field oxide 16 gradually tapers down into the oxide portion 12a. While this provides certain advantages, it will be understood that in certain applications, it is desirable to retain appropriate field oxide characteristics while increasing such taper so that active areas of adjacent semiconductor devices can be positioned more closely together.

Reference is made to Figs. 2a - 2f, wherein a silicon substrate 20 is provided with a thin layer of oxide 22 thereon, with a layer of silicon nitride 24 on the thin layer of oxide 22 (Fig. 2a). The nitride 24 is etched as previously described to act as a mask over the oxide 22, defining an opening exposing a portion of the oxide 22. Prior to growth of field oxide, a thin layer of polysilicon 28 is deposited over the structure (Fig. 2b). The resulting structure is then oxidized to grow the insulation region 30 (Figs. 2c and 2d). The oxide is then etched to provide the structure of Fig. 2e, and the nitride 24 is subsequently etched to provide the structure as shown in Fig. 2f.

It will be seen that the taper of the portion 32 is shown as somewhat greater in degree than the taper A' of the corresponding portion of the previous method. The achievement of this feature will now be explained.

During oxidation of the structure as shown in Fig. 2b, initial oxidation takes place along the exposed surface of the polysilicon 28. As this oxide grows, the polysilicon 28 is consumed until the nitride 24 and oxide layer 22 are reached thereby (Fig. 2c). Thus, an oxide layer 32 of a certain thickness has been grown without any lifting of the portions 24a, 24b of the nitride 24. This is to be compared with the prior art method wherein growing of the field oxide 16 from the very beginning lifts inner portions 14a, 14b of the nitride 14.

In the present method, further oxidation consumes some of the substrate 20, so that the field oxide 30 is fully grown (Fig. 2d). During this method step, the existence of the oxide layer 32 helps the nitride portions 24a, 24b to resist lifting as the field oxide 30 is grown, causing the taper between the field oxide 30 and the oxide portion 22a to be more extreme than if the nitride were lifted in accordance with the previous method.

The prior art method also has the problem that, upon growth of the field oxide 16 (Fig. 1c), oxinitride can under certain conditions form in the area 40, due to oxygen interacting with not only the substrate 10 but also with the nitride 14. As is well known, this oxinitride remains in place upon etching of the nitride layer 14, causing the gate oxide subsequently grown in the area 40 to grow at a less rapid rate than adjacent thereto. The present method avoids this problem since the nitride 24 is not exposed directly to oxygen during field oxide growth, as in the previous method.

It can be readily seen that the method may be practiced and realized with variations in temperatures, layer thickness and the like.

**0067738**

I claim:

1.  A method of forming an insulating region for a semiconductor device comprising:

>   providing a substrate of semiconductor material;

>   providing a layer of oxide over the substrate;

>   forming a mask over the oxide, which defines an opening exposing a portion of the oxide;

>   providing a layer of polysilicon over the resulting structure; and

>   oxidizing the resulting structure to grow an insulating region.

2.  The method of Claim 1 wherein the mask is formed of silicon nitride.

3.  The method of Claim 1 and further comprising the step of etching the oxide subsequent to the step of growing the insulating region.

1/1

FIG.1a

FIG.1b

FIG.1c

FIG.1d

FIG.2a

FIG.2b

FIG.2c

FIG.2d

FIG.2e

FIG.2f